# EUROPÄISCHE PATENTSCHRIFT

(11) **EP 2 815 207 B1**
(45) Veröffentlichungstag und Bekanntmachung des Hinweises auf die Patenterteilung: **15.08.2018**
(21) Anmeldenummer: 13708671.6
(22) Anmeldetag: 15.02.2013
(51) Int. Cl.: G01B 11/14, C30B 15/26

(54) **VERFAHREN ZUM MESSEN DES ABSTANDS ZWISCHEN ZWEI GEGENSTÄNDEN**
METHOD FOR MEASURING THE DISTANCE BETWEEN TWO OBJECTS
PROCÉDÉ DE MESURE DE LA DISTANCE ENTRE DEUX OBJETS

(30) Priorität: 16.02.2012 DE 102012003114
(43) Veröffentlichungstag der Anmeldung: 24.12.2014
(73) Patentinhaber: Audiodev GmbH, 52525 Heinsberg (DE)
(72) Erfinder: KUBITZEK, Rüdiger, 52511 Geilenkirchen (DE)
(74) Vertreter: Wimmer, Hubert
(86) Internationale Anmeldenummer: PCT/EP2013/000457
(87) Internationale Veröffentlichungsnummer: WO 2013/120625

(56) Entgegenhaltungen:
- US-A1- 2010 165 321
- US-B1- 6 572 699

## Beschreibung

Die Erfindung betrifft ein Verfahren zum optischen Messen des Abstands zwischen einem optisch im Wesentlichen streuenden und einem optisch im Wesentlichen spiegelnden Gegenstand mittels einer Lichtlinie unter Verwendung wenigstens einer Lichtquelle und wenigstens einem Lichtempfänger.

Optische Abstands-Messverfahren, wie Laserabstandsmessungen mittels Interferenz oder Laufzeitmessung, Lichtschnittverfahren oder weitere Triangulationsverfahren sind bekannt. Um hierbei auswertbare Lichtsignale zu erhalten, muss die Lichtquelle und in Bezug hierzu der Lichtempfänger in bestimmter Weise positioniert werden, um ausreichend starke, auswertbare Lichtsignale zu erhalten, die eine Abstandsmessung ermöglichen.

Lichtschnittverfahren sind als messtechnische Verfahren zur Messung des Höhenprofils von Oberflächen entlang einer projizierten Lichtlinie bekannt und für viele Anwendungen industriell im Einsatz. Sie basieren auf dem Prinzip der Triangulation. Hierfür ist es nötig, dass Lichtquelle, Lichtempfänger und Messprobe ein Dreieck bilden. Je größer der Winkel zwischen den optischen Achsen der Sende-. und Empfangsoptik ist, desto größer ist die Höhenauflösung der Messanordnung. Die auf einen Gegenstand projizierte Lichtlinie erfährt durch die Oberflächenkontur des Gegenstandes eine Deformation, welche mit einer Kamera als Lichtempfänger aufgenommen und ausgewertet wird. Je größer der Winkel zwischen Lichtquelle und dem Lichtempfänger ist, desto stärker ist die Verformung der Lichtlinie in dem Lichtempfänger sichtbar. Das bekannte Lichtschnittverfahren ist außerdem darauf angewiesen, dass die Oberfläche des zu vermessenden Gegenstandes hinreichend lichtstreuende Eigenschaften hat, so dass ein Teil des auf die Oberfläche des Gegenstands auftreffenden Lichts zur Empfangskamera diffus gestreut wird. Ist die Oberfläche jedoch spiegelnd oder in Teilbereichen spiegelnd, so dominiert dort der spiegelnde Glanzreflex an der Oberfläche. Dieser Spiegelreflex wird im All gemeinen nicht auf die Empfangsoptik treffen, so dass kein verwertbares Signal auf den Empfänger trifft.

In einigen Anwendungsfällen ist die Anwendung dieser herkömmlichen Verfahren zur Bestimmung des Abstands zwischen zwei Gegenständen dann nicht möglicht, wenn aufgrund spezieller geometrischer Verhältnisse keine auswertbaren Signale oder nur unspezifische Signale zur Bestimmung des Abstands zwischen einem im Wesentlichen streuenden Gegenstands und einem im Wesentlichen spiegelnden Gegenstands zu erhalten sind.

Beispielsweise sind die herkömmlichen optischen Abstandsmessverfahren nicht verwendbar, wenn einer der Gegenstände eine spiegelnde Oberfläche aufweist, während der andere Gegenstand das Licht streut, wie dies beispielsweise bei Kristallziehanlagen zur Herstellung monokristalliner Siliziumkristalle, sogenannter Ingots, der Fall ist, bei denen der Abstand zwischen einem im Wesentlichen streuenden Gegenstand, einem den Ingot umgebenden Trichter, und einem im Wesentlichen spiegelnden Gegenstand, einer heißen Siliziumschmelze, gemessen werden soll.

Aus den Druckschriften US 2010/0165321 und US 6 572699 B1 sind Mess-vorrichtungen und Messverfahren bekannt, bei denen eine Abstandsmessung in Zusammenhang mit Kristallziehverfahren durch Messen punktweiser Abstände mittels Triangulation vorgenommen wird. Das Gesamtergebnis setzt sich aus Ergebnissen mehrerer zeitlich aufeinander folgender Einzelmessungen an verschiedenen definierten Punkten zusammen.

Die Druckschrift US 2004/0095584 A1 beschreibt ein Verfahren und eine Vorrichtung zum Messen des Abstands einer Düse von einem spiegelnden Blechteil. Hierbei wird eine Laserlichtlinie parallel zum Blechteil und parallel zur Düsenkante auf der Düse projiziert. Die Laserlichtlinie liegt hierbei ausschließlich auf dem streuenden Gegenstand der Düse. Durch Aufnahme zweier paralleler Lichtlinien wird der Abstand dieser beiden Lichtlinien im Kamerabild ausgewertet, um auf diese Weise indirekt den Abstand des Düsenaustritts vom Blechteil zu bestimmen.

Der Erfindung liegt die Aufgabe zugrunde, ein Messverfahren anzugeben, mit dem es auch unter schwierigen geometrischen und lichttechnischen Gegebenheiten, wie beispielsweise bei Kristallziehverfahren, möglich ist, den Abstand zwischen einem im Wesentlichen streuenden und einem im Wesentlichen spiegelnden Gegenstand genau zu messen.

Diese Aufgabe wird erfindungsgemäß mit einem Verfahren nach Anspruch 1 gelöst. Vorteilhafte Weiterbildungen der Erfindung sind Gegenstand der abhängigen Ansprüche. Die Lichtlinie schließt sowohl wenigstens einen Bereich des streuenden als auch wenigstens einen Bereich des spiegelnden Gegenstands ein und sowohl das am streuenden Gegenstand gestreute als auch das am spiegelnden Gegenstand gespiegelte Licht der Lichtlinie wird aufgenommen und zur Bestimmung des Abstands ausgewertet, wobei das am streuenden Gegenstand gestreute Licht nach Spiegelung am spiegelnden Gegenstand und das am spiegelnden Gegenstand gespiegelte Licht nach Streuung am streuenden Gegenstand aufgenommen und ausgewertet wird.

Beim hier vorliegenden, erfindungsgemäßen Verfahren ist es im Gegensatz zu bekannten Lichtschnittverfahren, welche auf dem Prinzip der Triangulation beruhen, nicht notwendig, dass Lichtquelle, Lichtempfänger und Messprobe ein Dreieck bilden. Es wird bei dem erfindungsgemäßen Verfahren nicht die Verformung der Lichtlinie, also des Lichtschnitts, durch die Oberflächenkontur der Messprobe vermessen. Es ist im Gegenteil sogar vorteilhaft, wenn der Abstand zwischen Lichtquelle und Lichtempfänger sehr klein ist, oder diese sogar paraxial sind, was z.B. durch einen Strahlteiler erzielt werden kann, der die optischen Achsen der Lichtquelle und des Lichtempfängers überlagert. Im paraxialen Fall fallen die optischen Achsen von Lichtquelle und Lichtempfänger zusammen. Die Lichtlinie erscheint in diesem Fall aus der Perspektive des Lichtempfängers immer als Gerade, egal wie ausgeprägt das Höhenprofil des Gegenstandes ist, auf das die Lichtlinie auftrifft. Das erfindungsgemäße Verfahren beruht darauf, dass durch Spiegelung am spiegelnden Gegenstand zusätzliche Reflexe auftreten, die dann im vom Lichtempfänger aufgenommenen Bild ausgewertet werden können. Diese zusätzlichen Reflexe trennen sich geometrisch umso weiter auf, je größer der Abstand des streuenden Gegenstands vom spiegelnden Gegenstand ist.

Eine besonders vorteilhafte Ausführungsform des erfindungsgemäßen Verfahrens besteht darin, dass der streuende Gegenstand am Rand des dem spiegelnden Gegenstand zugewandten Endes eine Fase aufweist und dass das daran gestreute Licht aufgenommen und ausgewertet wird. Dadurch ergeben sich geometrisch definierte Reflexe und Spiegelreflexe der Leitlinie an der Fase, welche dann eine präzise Auswertung des vom Lichtempfänger ermittelten Bildes, beispielsweise eines Kamerabildes, erlauben.

Vorteilhaft ist es darüber hinaus, die Lichtlinie schräg zur Vertikalen zu verdrehen. Dadurch sind die auftretenden Reflexe und Spiegelreflexe horizontal zueinander versetzt und erleichtern die Auswertung des vom Lichtempfänger ermittelten Bildes durch diese geometrische Trennung.

Sehr vorteilhaft ist es gemäß einer weiteren Ausführungsform der Erfindung, wenn die Lichtquelle Licht in einem vorgegebenen Wellenbereich, vorzugsweise in einem violetten, blauen und/oder grünen Wellenlängenbereich emittiert. Vorteilhafterweise wird dabei der Wellenlängen-Aufnahmebereich des Lichtempfängers in Abhängigkeit vom Wellenlängenbereich des von der Lichtquelle, vorzugsweise mittels eines Bandpassfilters, begrenzt. Ein vorzugsweise schmalbandiger Wellenlängenbereich des Lichtempfängers im kurzwelligen Spektralbereich unterhalb 550 nm bei vorzugsweise hoher Intensität der Lichtquelle in diesem Wellenlängenbereich hat besondere Vorteile. Es wurde in Zusammenhang mit diesen Maßnahmen festgestellt, dass eine Schwarzkörperstrahlung des spiegelnden Gegenstands, wie etwa bei einer heißen Siliziumquelle, sehr effektiv gedämpft werden kann und dadurch das für die Messung ausgewertete Licht im Vergleich zur ausgefilterten Schwarzkörperstrahlung dominiert, was zu einfacheren und genaueren Abstands-Messergebnissen führt.

Vorzugsweise ist der Lichtempfänger eine Digital- bzw. Matrix oder Zeilenkamera.

Um nicht nur den Abstand, sondern auch die Schieflage zwischen den streuenden und spiegelnden Gegenständen zu ermitteln, ist es vorteilhaft, den Abstand an wenigstens zwei zwischen den Gegenständen gewählten Stellen zu bestimmen.

Das erfindungsgemäße Verfahren ist besonders vorteilhaft in Zusammenhang mit Kristallziehanlagen anwendbar, bei denen der im Wesentlichen streuende Gegenstand ein einen Ingot umgebender Trichter und der im Wesentlichen spiegelnde Gegenstand eine heiße Siliziumschmelze ist.

Zur Herstellung von monokristallinen Siliziumsolarzellen werden monokristalline Siliziumwafer benötigt. Das wichtigste Verfahren zur Herstellung dieser Wafer besteht darin, dass ein monokristalliner Ingot beispielsweise mittels des sogenannten Czochralsky-Kristallziehverfahrens langsam aus einer heißen Siliziumschmelze gezogen wird. Durch das langsame Kristallwachstum dauert dieser Prozess üblicherweise mehrere Tage. Anschließend wird der Kristall zugeschnitten und dann mit Sägemaschinen in Wafer zersägt, die dann zur Herstellung der Solarzellen weiterverarbeitet werden.

Der Czochralsky-Kristallziehprozess ist ein empfindlicher Prozess, bei dem es häufig zum Strukturbruch des Kristalls kommt. Dann muss der Ziehprozess abgebrochen und von neuem begonnen werden. Auch kann es durch Prozessinstabilitäten zu Durchmesserschwankungen des Kristalls oder zu einer qualitätsmindernden erhöhten Anzahl von Fehlstellen im Kristall kommen. Oder der Kristall muss aufgrund von Prozessinstabilitäten mit einer niedrigen Ziehgeschwindigkeit gezogen werden.

Für den Kristallziehprozess ist es besonders wichtig, in der Czochralsky-Anlage thermisch stabile Verhältnisse der heißen Siliziumschmelze und des Luftraums über der Schmelze während des Ziehprozesses zu gewährleisten. Dies ist wichtig, um einen Strukturbruch des Monokristalls zu verhindern, sowie um die Ziehgeschwindigkeit des Kristalls maximieren zu können und um einen möglichst konstanten Durchmesser des Ingots über die Höhe zu bekommen. Zur Erzielung einer verbesserten Stabilität der Temperaturverteilung in der Czochralsky -Anlage werden meist trichterförmige Einsätze verwendet, die den Ingot zylindersymmetrisch umschließen und die mit der Unterkante des Trichters möglichst nahe an die Schmelze heranreichen. Die Kontrolle des Abstandes der Trichterunterkante von der Schmelze ist dabei ein wichtiger Prozessparameter. Es ist jedoch schwierig diesen Abstand präzise zu kontrollieren und zu regeln. Dieser Abstand sollte sehr klein sein, ohne die Schmelze zu berühren und er sollte während des Ziehprozesses konstant gehalten, oder eventuell sogar während des Ziehprozesses in einer vordefinierten Weise verändert werden. Für die Einhaltung der gewünschten Abstände zwischen Trichter und Schmelze bzw. der Abstandsregelung ist das erfindungsgemäße Verfahren besonders gut geeignet.

Mit den herkömmlichen optischen Messverfahren ist die Abstandsmessung deshalb schwierig, weil lediglich ein Einblick über Schaugläser aus ungünstiger Perspektive von schräg oben, noch dazu in einem sehr steilen Winkel, in die Kammer mit der Schmelze möglich ist, und weil die hohen Temperaturen und das Eigenleuchten der Schmelze bei ca. 1500°C eine optische Messung enorm erschweren. Mit dem erfindungsgemäßen Verfahren werden diese Schwierigkeit und Einschränkungen überwunden.

Das erfindungsgemäße Verfahren sowie dessen Vorteile wird bzw. werden nachfolgend anhand einer Kristallziehanlage als Ausführungsbeispiel im Einzelnen erläutert. Es zeigen:
- Fig. 1: eine schematische Querschnittsdarstellung einer Czochralsky-Kristallziehanlage;
- Fig. 2: die in Fig. 1 dargestellte Anlage in perspektivischer Darstellung;
- Fig. 3 bis 5: schematische Lichtstrahlverläufe zur Erläuterung des erfindungsgemäßen Verfahrens;
- Fig. 6: Strahlenverläufe im Falle einer besonderen Ausführungsform, bei der der Rand des streuenden Gegenstands, im vorliegenden Fall des Trichters, eine Fase aufweist;
- Fig. 7: eine vergrößerte Darstellung der in Fig. 6 gezeigten Ausführungsform mit schematischen Strahlverläufen; und
- Fig. 8: einen vergrößerten Ausschnitt aus Fig. 2 in Blickrichtung des Lichtempfängers.

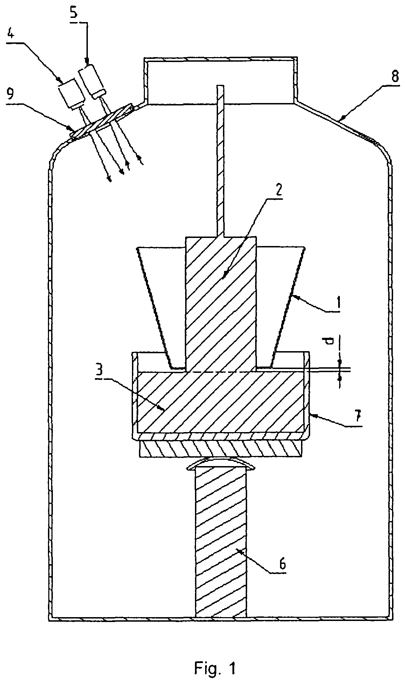

Fig. 1 zeigt einen Ausschnitt einer Czochralsky-Kristallziehanlage mit Sicherheitsbehälter 8, heißer Siliziumschmelze 3 in einem Tiegel 7, welcher durch eine Hubvorrichtung 6 vertikal verschoben werden kann, einen Monokristall (Ingot) 2 während des Ziehprozesses, einen Trichter 1, welcher den Kristall 2 zylindersymmetrisch umschließt und mit seiner Unterkante bis zu einem freien Abstand d wenige Millimeter an die Schmelze 3 heranreicht. Im Sicherheitsbehälter 8 befinden sich in der Regel mehrere Schaugläser 9. In einer vorteilhaften Anordnung sind eine Lichtquelle 4 und eine Empfangskamera 5 möglichst eng nebeneinander angeordnet und blicken durch dasselbe Schauglas 9. Es ist jedoch auch möglich, Lichtquelle 4 und Empfänger 5 weiter zu beabstanden und an zwei getrennten Schaugläsern anzubringen.

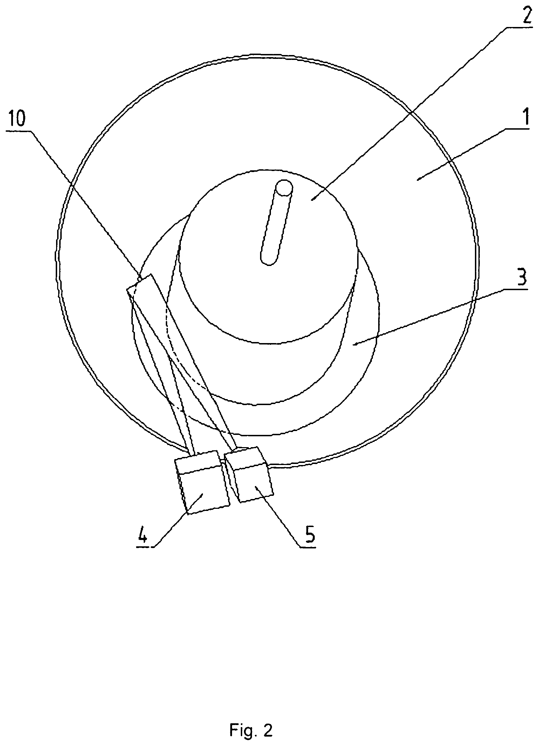

Fig. 2 zeigt dieselbe Anordnung in Blickrichtung schräg von oben. Hier ist eine von der Lichtquelle 4 projizierte und von der Kamera 5 empfangene Lichtlinie 10 abgebildet, welche sowohl die Unterkante des Trichters 1 als auch den an die Trichterkante angrenzenden Teil der Siliziumschmelze 2 einschließt. Die Lichtkegel von der Lichtquelle 4 und zu der Kamera 5 sind ebenfalls eingezeichnet.

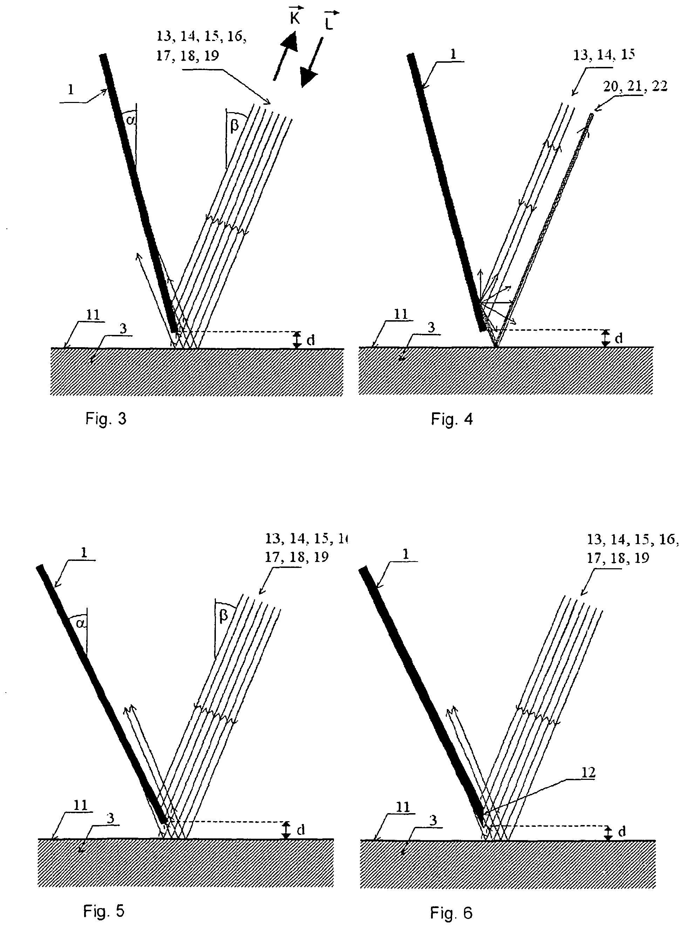

Die bei dieser Anordnung auftretenden Lichtreflexe, die von der Kamera empfangen und ausgewertet werden, sind in den Figuren 3 bis 7 schematisch dargestellt. In den Fig. 3 bis 7 ist für die bessere Verständlichkeit angenommen, dass die optischen Achsen von Lichtquelle 4 und Empfänger 5 paraxial sind mit parallelen entgegengesetzten Richtungsvektoren L und K der gesendeten (beleuchtenden) und der empfangenen (reflektierten bzw. gestreuten) Lichtstrahlen, wobei die gesendeten Lichtstrahlen ein paralleles, schmales Lichtbündel (Lichtlinie) sind und nur paralleles Licht, welches in dieselbe Richtung wie der Sendestrahl zurückgestreut oder zurückreflektiert wird, von der Empfangskamera 5 empfangen wird.

Außerdem ist vereinfachend angenommen, dass die Lichtlinie 10, die Einstrahlrichtung L und die Empfangsrichtung K des Lichts, sowie der Normalenvektor des Trichters 1 entlang der Auftrefflinie der Lichtlinie 10, allesamt in der Zeichnungsebene liegen. Dies ist in Fig. 3 dargestellt. Hier sind der Trichter 1, die Siliziumschmelze 3 mit einer spiegelnden Oberfläche 11 zu sehen. Der Trichter 1 schließt einen Winkel α mit dem Normalenvektor auf der Siliziumschmelze 3 ein und hat einen freien Abstand d von der Oberfläche 11 der Siliziumschmelze 3. Das aus der Richtung L eingestrahlte parallele Lichtbündel bildet eine Linie in der Zeichnungsebene. Diese kontinuierliche Lichtlinie 10 ist hier durch sieben Lichtstrahlen 13, 14, 15, 16, 17, 18, 19 repräsentiert (von links nach rechts), wobei der Abstand von Strahl 13 zu Strahl 19 die Länge der Lichtlinie angibt.

Senkrecht zur Zeichnungsebene ist die Ausdehnung der Lichtlinie 10 als vernachlässigbar klein angenommen. Die Einstrahlrichtung L schließt einen Winkel β mit dem Normalenvektor auf die Oberfläche 11 der Siliziumschmelze 3 ein.

In den Figuren 3 und 4 gilt für die Winkel α und β: α < β. Die Strahlen 13, 14, 15 treffen direkt auf den Trichter 1 auf und werden dort an der rauen Oberfläche des Trichters 1 gestreut. Die Anteile des gestreuten Lichts, die in Richtung K gestreut werden, wie in Fig. 4 zu sehen ist, werden von der Kamera 5 empfangen und sind daher im Kamerabild zu sehen. Dieser Strahlengang wird im Folgenden als L-T-K bezeichnet (Lichtquelle-Trichter-Kamera).

In Fig. 4 ist beispielhaft der Auftreffpunkt von Strahl 13 auf den Trichter 1 gezeigt, an dem das Licht in alle Richtungen gestreut wird. Daher wird auch ein Teil des Lichts der Strahlen 13, 14, 15 in Richtung Siliziumschmelze 3 gestreut und dort spiegelnd reflektiert. Die Anteile des dort reflektierten Lichts, das in Richtung K reflektiert wird, sind die Strahlen 20, 21, 22 in Fig. 4. Sie werden von der Kamera 5 empfangen und sind daher im Kamerabild zu sehen. Dieser Strahlengang wird im Folgenden als L-TS-K (Lichtquelle-Trichter-Schmelze-Kamera) bezeichnet.

Wie aus Fig. 5 oder 6 zu ersehen ist, trifft der Strahl 16 auf die Oberfläche 11 der Siliziumschmelze 3 und wird von dort hinter den Trichter 1 spiegelnd reflektiert. Dieser Reflex ist von der Kamera 5 nicht zu sehen. Der Strahl 17 trifft auf die Oberfläche 11 der Siliziumschmelze 3, wird dort spiegelnd reflektiert und trifft dann von unten auf die Kante des Trichters 1 und wird dort gestreut. Das gestreute Licht trifft dann nochmals auf die Siliziumschmelze 3, wird teilweise in Richtung K zur Kamera 5 reflektiert und ist dann ebenfalls im Kamerabild sichtbar. Dieser Reflex ist zwar grundsätzlich für die Auswertung verwendbar, aber aufgrund der zweimaligen Reflexion an der Oberfläche 11 der Schmelze 3 und aus geometrischen Gründen weniger gut dafür geeignet. Dieser Strahlengang wird im Folgenden als L-STS-K bezeichnet. Die Strahlen 18 und 19 treffen auf die Oberfläche 11 der Siliziumschmelze 3, werden dort spiegelnd reflektiert und treffen dann auf den Trichter 1. Die Anteile des dann am Trichter 1 gestreuten Lichts, welche in Richtung K gestreut werden, werden von der Kamera 5 empfangen und sind im Kamerabild zu sehen. Dieser Strahlengang wird im Folgenden als L-ST-K bezeichnet (Lichtquelle-Schmelze-Trichter-Kamera). Die auftretenden Strahlengänge, die in der Kamera auswertbare Abbildungen von Teilen der Lichtlinie liefern, sind also:
L-T-K (Lichtquelle-Trichter-Kamera)
L-ST-K (Lichtquelle-Schmelze-Trichter-Kamera)
L-TS-K (Lichtquelle-Trichter-Schmelze-Kamera)
L-STS-K (Lichtquelle-Schmelze-Trichter-Schmelze-Kamera)

Dabei kann der Reflex L-STS-K zwar für die Auswertung herangezogen werden, ist jedoch hierfür weniger geeignet als die drei anderen Reflexe, da er durch die zweimalige Spiegelreflexion an der Schmelze 3 in der Intensität abgeschwächt ist und durch die doppelte Spiegelung mehr Störungen hat. Außerdem führt der Trichter 1 selbst zu einer teilweisen Abschattung dieses Strahlgangs, wenn der Abstand d klein ist. Daher wird dieser Strahlengang im Folgenden außer acht gelassen.

Im Folgenden werden die geometrischen Eigenschaften und die Intensitätseigenschaften der drei Strahlengänge L-T-K, L-ST-K, L-TS-K betrachtet.
L-T-K: Die Intensität des in die Kamera 5 zurückgestreuten Signals wird durch die Streueigenschaften der Trichteroberfläche bestimmt. Wie in Fig. 4 zu sehen ist, sind die Abstände der einlaufenden Strahlen 13, 14, 15 identisch mit den Abständen der in die Kamera 5 zurückgestreuten Strahlen. Die Strahlenbündel liegen aufeinander. Daher gibt es keine perspektivische Kompression oder Expansion des empfangenen Strahlenbündels gegenüber dem beleuchtenden Strahlenbündel. Sowohl das beleuchtende, als auch das empfangene Strahlenbündel schließen einen Winkel β + α mit dem Trichter 1 ein.
L-TS-K: Der Winkel des gestreuten Lichts mit dem Trichter 1 ist β - α, also sehr flach. Daher ist das zur Kamera reflektierte Lichtbündel perspektivisch um den Faktor sin(β-α)/sin(β+α) komprimiert, es erscheint im Kamerabild also verkürzt. Dies ist in Fig. 4 daran zu sehen, dass die Strahlen 20, 21, 22 deutlich dichter beieinander liegen, als die Strahlen 13, 14, 15.
L-ST-K: Das Licht trifft nach Reflexion an der Oberfläche 11 der Schmelze 3 auf den Trichter 1 und schließt ebenfalls einen Winkel β - α mit dem Trichter 1 ein. Das unter dem Winkel β + α in die Kamera 5 gestreute Licht ist daher um den Faktor sin(β+α)/sin(β-α) perspektivisch verlängert. Dies ist in Fig. 3 an den weit auseinander liegenden Auftreffpunkten der an der Oberfläche 11 der Schmelze 3 reflektierten Strahlen 18 und 19 auf dem Trichter 1 zu sehen. Dadurch erscheint dieses Linienstück im Kamerabild perspektivisch verlängert und dadurch seine Strahldichte bzw. Helligkeit im Kamerabild erheblich abgeschwächt.

Je geringer die Winkeldifferenz β - α ist, desto ungünstiger sind also die geometrischen Verhältnisse und die Intensitätsverhältnisse für die Messung. Die perspektivische Kompression und Expansion von L-TS-K und von L-ST-K nehmen für kleine Werte β - α zu, und ihre Helligkeitsunterschiede im Kamerabild nehmen dann ebenfalls zu, was die Anforderungen an den Dynamikbereich der Kamera 5 erhöht.

Ist der Trichterwinkel α größer als β, so verschwinden die Reflexe L-TS-K und L-ST-K ganz. Dies ist in Fig. 5 zu sehen. In Fig. 5 ist α > β. Die Strahlen 18 und 19 treffen nicht mehr auf den Trichter 1. Auch die Strahlen 20 und 21, wie sie in Fig. 4 gezeigt sind, werden durch den Trichter 1 abgeschattet. Eine Messung ist in diesem Fall nicht möglich.

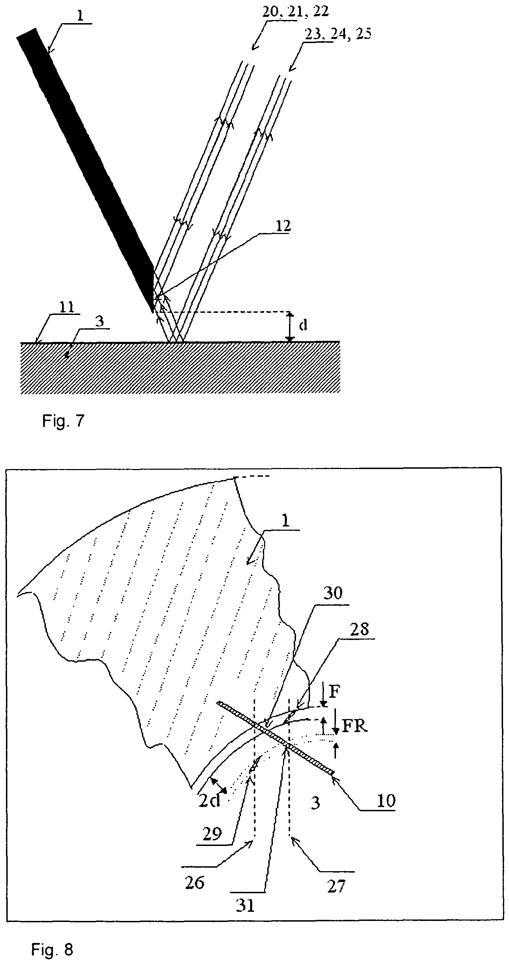

In der Praxis sind durch den Anlagenbauer oder durch den Betreiber der Ziehanlagen die Position der Schaugläser 9 und der Trichterwinkel vorgegeben. Dies schränkt die möglichen Winkelbereiche für α und β in der Regel sehr stark ein und macht eine Messung ggf. sogar unmöglich. Dann kann die erfindungsgemäße Anordnung nicht verwendet werden. Diese Problematik kann aber erfindungsgemäß in einer besonders vorteilhaften Ausführung dadurch behoben werden, dass an den Trichter 1 an der unteren Kante eine vertikale Fase 12 angeschliffen ist. Diese ist in Fig. 6 und vergrößert in Fig. 7 dargestellt. In Fig. 7 sind nur die Strahlwege über diese Fase 12 dargestellt. Man sieht hier an den bidirektionalen Strahlen 20, 21, 22 und 23, 24, 25, dass die Strahlwege L-ST-K und L-TS-K jetzt völlig symmetrisch sind, und dass die an der Schmelze reflektierten Strahlen stets einen Winkel β mit dem Normalenvektor einschließen und die an der Fase 12 gestreuten Strahlen stets einen Winkel 90°-β mit dem Normalenvektor auf die Fase 12 einschließen. Dies gilt in dieser sehr vorteilhaften Ausführung für alle drei Strahlengänge L-T-K, L-ST-K und L-TS-K. Dadurch haben die beiden Reflexe L-ST-K und L-TS-K im Kamerabild die gleiche Helligkeit und die gleiche Länge. Die Helligkeit von L-ST-K und L-TS-K ist gegenüber der Helligkeit von L-T-K lediglich um einen festen Faktor gemindert. Dieser Faktor ist der Oberflächenreflexionsgrad der Oberfläche 11 der Schmelze 3, denn in den Strahlengängen L-ST-K und L-TS-K tritt eine zusätzlich Reflexion an der Oberfläche 11 der Schmelze 3 auf, die es im Strahlengang L-T-K nicht gibt. Somit ist die Anordnung mit Fase 13 am Trichter 1 besonders vorteilhaft, denn sie schafft stabile und günstige geometrische Verhältnisse und Helligkeitsverhältnisse und macht die Anordnung unabhängig vom Trichterwinkel des Trichters 1 und von der Position der Schaugläser 9.

Für eine Auswertung der Strahlengänge L-T-K, L-ST-K und L-TS-K im Kamerabild ist es nötig, dass diese Strahlengänge im Kamerabild getrennt sind. In den Figuren 3 und 7 ist aber zu sehen, dass L-T-K und L-ST-K aufeinanderliegen. Dieses Problem wird gemäß einer erfindungsgemäßen weiteren Ausführungsform dadurch behoben, dass die Lichtlinie gedreht wird. In den Figuren 3 bis 7 liegt die Lichtlinie in der Zeichnungsebene, also in derselben Ebene, die auch durch den Normalenvektor auf der Oberfläche 11 der Schmelze 3 und den Richtungsvektor (optische Achse) der Kamera 5 aufgespannt wird. Wird die Linie aber gedreht, so liegen die Strahlen 13 bis 19 in Fig. 3 senkrecht zur Zeichnungsebene hintereinander versetzt und dadurch werden auch die Strahlengänge L-T-K und L-ST-K in dieser Richtung voneinander getrennt. Dies gilt unabhängig davon, ob dort der Normalenvektor auf dem Trichter 1 in der Zeichnungsebene liegt, oder nicht. Es ist also auch gleichgültig, welcher Bereich des Trichters 1 mit der Lichtlinie beleuchtet wird. Dies ist insbesondere deshalb wichtig, weil die dem Schauglas 9 gegenüberliegende Seite des Trichters 1 während des Ziehprozesses durch den Ingot 2 verdeckt wird. Daher muss während des Ziehprozesses die Messung links oder rechts am Ingot 2 vorbei erfolgen.

Fig. 8 zeigt vergrößert den Ausschnitt mit der Lichtlinie 10 aus Fig. 2, jetzt jedoch genau aus der Blickrichtung der Kamera 5. Es ist hier ein Ausschnitt des Trichters 1 gezeigt. Zusätzlich sind in Fig. 8 die relevanten Spiegelreflexe an der Oberfläche 11 der Schmelze 3 eingezeichnet. In Fig. 8 ist die Lichtlinie 10 in vorteilhafter Weise gedreht und die Unterkante des Trichters 1 hat eine Fase der Breite F. Das Spiegelbild FR der Fase F auf der Oberfläche 11 der Schmelze 3 ist ebenfalls eingezeichnet. Der Abstand zwischen F und FR ist proportional zu 2d, wobei d der Abstand zwischen Trichter 1 und Schmelze 3 ist, welcher mit der Messanordnung gemessen wird. Das Teilstück 30 der Lichtlinie beleuchtet die Fase F und ist direkt im Kamerabild zu sehen. Außerdem spiegelt es sich als Spiegelreflex 29 in der Oberfläche 11 der Schmelze 3, wobei die Spiegelebene 26 durch den Normalenvektor auf die Oberfläche 11 der Schmelze 3 und die Betrachtungsrichtung der Kamera 5 aufgespannt wird. Das Teilstück 31 der Lichtlinie, dass auf den Bereich FR der Siliziumschmelze 3 trifft, spiegelt sich in der Schmelze und trifft dann als Reflex 28 auf die Fase F des Trichters 1. Diese Spiegelung erfolgt entlang der Spiegelebene 27. Die Reflexe 30, 29 und 28 sind die bereits anhand der Figuren 3 bis 7 diskutierten Strahlengänge L-T-K, L-ST-K und L-TS-K. Durch die Drehung der Lichtlinie liegen die Strahlengänge L-ST-K, L-TS-K und L-T-K im Kamerabild seitlich versetzt, wobei der Versatz proportional zum Abstand d ist, der mit der Anordnung gemessen wird. In dem speziellen Fall, dass die Lichtlinie 10 nicht gedreht ist, also parallel zur Spiegelebene 26 (bzw. 27) liegt, findet keine seitliche Aufspaltung statt. Die eingestrahlte Lichtlinie und die Strahlengänge 28, 29 und 30 liegen dann für eine Messung unvorteilhaft entlang einer Linie und teilweise aufeinander.

Die hier beschriebenen erfindungsgemäßen Messprinzipien bleiben auch dann gültig, wenn die Lichtquelle 4 und die Kamera 5 nicht paraxial sind oder wenn sie sogar deutlich voneinander beabstandet sind und damit einen großen Winkel einschließen. Dies ist z.B. dann der Fall, wenn Lichtquelle 4 und Kamera 5 an zwei getrennten Schaugläsern der Anlage angebracht werden. Die geometrischen Verhältnisse und die Auswertung der Strahlengänge im Kamerabild werden dann jedoch komplexer.

Die hier beschriebenen erfindungsgemäßen Messprinzipien bleiben weiterhin auch dann gültig, wenn die Kamera 5 und die Lichtquelle 4 nicht mit parallelen Strahlen arbeiten, sondern beispielsweise die beleuchtende Lichtlinie 10 eine Strahldivergenz in der Ebene der Linie aufweist. Dies ist beispielsweise dann der Fall, wenn als Lichtquelle 4 ein Laser mit zunächst parallelem Strahl verwendet wird und dieser Strahl dann mittels einer Zylinderlinse einachsig zu einer divergierenden Lichtlinie aufgeweitet wird.

In einer vorteilhaften erfindungsgemäßen Ausführungsform erfolgt die Messung im kurzwelligen Spektralbereich, wobei die sehr intensive und andernfalls außerordentlich störende Wärmestrahlung der Siliziumschmelze 3 durch einen schmalbandigen Bandpassfilter in der Kamera 5 unterdrückt wird. Vorteilhafterweise wird hierfür ein Laser im kurzwelligen Spektralbereich, vorzugsweise im blauen oder violetten Spektralbereich, und ein zur Laserwellenlänge passender schmalbandiger Bandpassfilter in der Kameraoptik verwendet.

Erfindungsgemäß kann statt der Lichtlinie auch ein entlang einer Linie scannender Lichtpunkt verwendet werden.

Das erfindungsgemäße Verfahren wurde zuvor am Beispiel einer Kristallziehanlage beschrieben. Die Anwendung des erfindungsgemäßen Verfahrens ist jedoch nicht auf dieses Anwendungsbeispiel beschränkt, sondern auch in zahlreichen weiteren Anwendungsfällen zur Bestimmung der freien Abstände von wenigstens zwei Gegenständen unter speziellen und komplizierten geometrischen und anwendungstechnischen Verhältnissen mit Vorteil einsetzbar.

## Patentansprüche

1. Verfahren zum optischen Messen des Abstands (d) zwischen einem im Wesentlichen streuenden (1, T) und einem im Wesentlichen spiegelnden Gegenstand (3, S) mittels einer Lichtlinie (10) unter Verwendung wenigstens einer Lichtquelle (4) und wenigstens eines Lichtempfängers (5), wobei die Lichtlinie (10) sowohl wenigstens einen Bereich des streuenden (1) als auch wenigstens einen Bereich des spiegelnden Gegenstands (3) einschließt, **dadurch gekennzeichnet, dass** sowohl ein Teilstück der Lichtlinie (10), welches zuerst am streuenden Gegenstand (1) gestreut und danach am spiegelnden Gegenstand (3) gespiegelt (Strahlengang Lichtquelle L - Trichter T - Schmelze S - Kamera K) wird, aufgenommen wird, dann ein Teilstück der Lichtlinie (10), welches zuerst am spiegelnden Gegenstand (3) gespiegelt und danach am streuenden Gegenstand (1) gestreut (Strahlengang Lichtquelle L - Schmelze S - Trichter T-Kamera K) wird, aufgenommen wird, und ein Teilstück der Lichtlinie (10), welches am streuenden Gegenstand (1) gestreut (Strahlengang Lichtquelle L - Trichter T - Kamera K) wird, aufgenommen wird, wobei die drei Teilstücke im Lichtempfänger (5) zueinander versetzt abgebildet werden, und dieser Versatz, der proportional zum Abstand (d) ist, ermittelt wird.

2. Verfahren nach Anspruch 1, **dadurch gekennzeichnet, dass** der streuende Gegenstand (1) am Rand seines dem spiegelnden Gegenstand zugewandten Endes eine Fase (12) aufweist, und das daran gestreute Licht aufgenommen wird.

3. Verfahren nach Anspruch 1 oder 2, **dadurch gekennzeichnet, dass** zu einer Versetzung der auftretenden Reflexe und Spiegelreflexe horizontal zueinander die Lichtlinie (10) verdreht ist.

4. Verfahren nach einem der vorhergehenden Ansprüche, **dadurch gekennzeichnet, dass** die Lichtquelle (4) Licht in einem vorgegebenen Wellenlängenbereich, vorzugsweise in einem violetten, blauen und/oder grünen Wellenlängenbereich emittiert.

5. Verfahren nach Anspruch 4, **dadurch gekennzeichnet, dass** der Wellenlängen-Aufnahmebereich des Lichtempfängers (5) in Abhängigkeit vom Wellenlängenbereich des von der Lichtquelle abgegebenen Lichts, vorzugsweise mittels eines Bandpassfilters, begrenzt wird.

6. Verfahren nach Anspruch 4 oder 5, **dadurch gekennzeichnet, dass** der Wellenlängen-Aufnahmebereich des Lichtempfängers (5) in einem vorzugsweise schmalen Wellenlängenbereich kleiner als 550 nm liegt.

7. Verfahren nach einem der vorhergehenden Ansprüche, **dadurch gekennzeichnet, dass** als Lichtlinie (10) ein linear scannender Lichtpunkt verwendet wird.

8. Verfahren nach einem der vorhergehenden Ansprüche, **dadurch gekennzeichnet, dass** der Lichtempfänger (5) eine Digital- bzw. Matrix oder Zeilenkamera ist.

9. Verfahren nach einem der vorhergehenden Ansprüche, **dadurch gekennzeichnet, dass** zur Bestimmung einer Schieflage der Abstand zwischen dem streuenden (1) und dem spiegelnden Gegenstand (3) an wenigstens zwei unterschiedlichen Stellen bestimmt wird.

10. Verfahren nach einem der vorhergehenden Ansprüche, **dadurch gekennzeichnet, dass** der streuende Gegenstand (1) ein einen Ingot umgebender Trichter und der spiegelnde Gegenstand (3) eine heiße Siliziumschmelze in einer Kristallziehanlage ist.

## Claims

1. Method for optically measuring the distance (d) between a substantially scattering object (1, T) and a substantially reflecting object (3, S) by means of a line of light (10) using at least one light source (4) and at least one light receiver (5), wherein the line of light (10) includes at least one region of the scattering object (1) and also at least one region of the reflecting object (3), **characterized in that** both a part-section of the line of light (10), which is firstly scattered at the scattering object (1) and thereafter is reflected at the reflecting object (3) (light path light source L - funnel T - melt S - camera K), is captured, then a part-section of the line of light (10), which is firstly reflected at the reflecting object (3) and thereafter scattered at the scattering object (1) (light path light source L - melt S - funnel T - camera K), is captured, and a part-section of the line of light (10), which is scattered at the scattering object (1) (light path light source L - funnel T - camera K) is captured, wherein the three part-sections are imaged displaced to each other in the light receiver (5), and this displacement which is proportional to the distance (d), is determined.

2. Method in accordance with claim 1, **characterized in that** the scattering object (1) has a chamfer (12) at the edge of the end thereof facing the reflecting object, and the light scattered thereat is captured.

3. Method in accordance with claim 1 or 2, **characterized in that** the line of light (10) is rotated horizontally to each other to the displacement of the occurring reflexes and mirror reflexes.

4. Method in accordance with any of the preceding claims, **characterized in that** the light source (4) emits light in a given wavelength range, preferably in a violet, blue and/or green wavelength range.

5. Method in accordance with claim 4, **characterized in that** the wavelength capture range of the light receiver (5) is limited in dependence on the wavelength range of the light delivered by the light source, preferably by means of a bandpass filter.

6. Method in accordance with claim 4 or 5, **characterized in that** the wavelength capture range of the light receiver (5) lies in a preferably narrow wavelength range smaller than 550 nm.

7. Method in accordance with any of the preceding claims, **characterized in that** a linear scanning light spot is used as the line of light (10).

8. Method in accordance with any of the preceding claims, **characterized in that** the light receiver (5) is a digital or matrix camera or a line camera.

9. Method in accordance with any of the preceding claims, **characterized in that** the distance between the scattering (1) and the reflecting object (3) is determined at at least two different positions for the purposes of determining an inclination.

10. Method in accordance with any of the preceding claims, **characterized in that** the scattering object (1) is a funnel surrounding an ingot and the reflecting object (3) is a hot silicon melt in a crystal pulling plant.

## Revendications

1. Procédé pour mesurer optiquement la distance (d) entre un objet sensiblement diffusant (1, T) et un objet sensiblement réfléchissant (3, S) au moyen d'une ligne de lumière (10) en utilisant au moins une source de lumière (4) et au moins un récepteur de lumière (5), dans lequel la ligne de lumière (10) comprend au moins une région de l'objet diffusant (1) et aussi au moins une région de l'objet réfléchissant (3), **caractérisé en ce qu'**à la fois une section partielle de la ligne de lumière (10), qui est d'abord diffusée au niveau de l'objet diffusant (1) puis est ensuite réfléchie au niveau de l'objet réfléchissant (3) (chemin de lumière source de lumière L - entonnoir T - matière en fusion S - caméra K) est capturée, puis une section partielle de la ligne de lumière (10), qui est d'abord réfléchie au niveau de l'objet réfléchissant (3) puis est ensuite diffusée au niveau de l'objet diffusant (1) (chemin de lumière source de lumière L - matière en fusion S - entonnoir T - caméra K) est capturée, et une section partielle de la ligne de lumière (10), qui est diffusée au niveau de l'objet diffusant (1) (chemin de lumière source de lumière L - entonnoir T - caméra K) est capturée, dans lequel les trois sections partielles sont capturées en images déplacées l'une par rapport à l'autre dans le récepteur de lumière (5), et ce déplacement, qui est proportionnel à la distance (d), est déterminé.

2. Procédé selon la revendication 1, **caractérisé en ce que** l'objet diffusant (1) comporte un chanfrein (12) au niveau du bord de son extrémité orientée vers l'objet réfléchissant, et la lumière diffusée au niveau de celui-ci est capturée.

3. Procédé selon la revendication 1 ou 2, **caractérisé en ce que** la ligne de lumière (10) est tournée horizontalement l'un par rapport à l'autre au déplacement des reflets qui se produisent et des reflets de miroir.

4. Procédé selon l'une quelconque des revendications précédentes, **caractérisé en ce que** la source de lumière (4) émet de la lumière dans une plage de longueurs d'onde donnée, de préférence dans la plage de longueurs d'onde du violet, du bleu et/ou du vert.

5. Procédé selon la revendication 4, **caractérisé en ce que** la plage de capture de longueurs d'onde du récepteur de lumière (5) est limitée en fonction de la plage de longueurs d'onde de la lumière fournie par la source de lumière, de préférence au moyen d'un filtre passe-bande.

6. Procédé selon la revendication 4 ou 5, **caractérisé en ce que** la plage de capture de longueurs d'onde du récepteur de lumière (5) se trouve de préférence dans une plage de longueurs d'onde étroite plus petite que 550 nm.

7. Procédé selon l'une quelconque des revendications précédentes, **caractérisé en ce qu'**un point lumineux à balayage linéaire est utilisé comme ligne de lumière (10).

8. Procédé selon l'une quelconque des revendications précédentes, **caractérisé en ce que** le récepteur de lumière (5) est une caméra numérique ou à matrice ou une caméra linéaire.

9. Procédé selon l'une quelconque des revendications précédentes, **caractérisé en ce que** la distance entre l'objet diffusant (1) et l'objet réfléchissant (3) est déterminée au niveau d'au moins deux positions différentes dans le but de déterminer une inclinaison.

10. Procédé selon l'une quelconque des revendications précédentes, **caractérisé en ce que** l'objet diffusant (1) est un entonnoir entourant un lingot et l'objet réfléchissant (3) est du silicium chaud en fusion dans une installation de tirage de cristal.
